# EUROPEAN PATENT APPLICATION

(11) **EP 3 416 466 A1**
(43) Date of publication of application: **19.12.2018**
(21) Application number: 18150787.2
(22) Date of filing: 09.01.2018
(51) Int. Cl.: H05K 7/14

(54) **SYSTEM FOR DETERMINING SLOT LOCATION IN AN EQUIPMENT RACK**

(30) Priority: 14.06.2017 US 201762519565 P; 18.10.2017 US 201715787362
(71) Applicant: Quanta Computer Inc., Taoyuan City 33377 (TW)
(72) Inventor: SHIH, Ching-Chih, 33377 Taoyuan City (TW)
(74) Representative: Krauns, Christian

(57) **Abstract**

A system to record equipment location in an equipment rack is disclosed. The system includes a rack having a plurality of slots. One of the slots holds a management switch including a plurality of ports. Each of a plurality of network devices is installed in one of the plurality of slots. Each of the plurality of network devices is connected to one of the plurality of ports of the management switch sequentially according to the slot of each of the plurality of network devices. Identification information associated with the management switch is sent to each of the plurality of network devices. Device identification data is determined for each of the plurality of network devices. Rack location information is based on the identification information associated with the management switch and the device identification data associated with each network device is stored.

## Description

### TECHNICAL FIELD

The present disclosure relates generally to a device identification and location system for a data center. More particularly, aspects of this disclosure relate to using different methods to identify the slot of a rack mounted device in a data center.

### BACKGROUND

The emergence of the cloud for computing applications has increased the demand for off-site installations, known as data centers, which store data and run applications accessed by remotely connected computer device users. Such data centers typically have massive numbers of servers, switches and storage devices to store and manage data, so they may be accessed in a convenient manner by remote computer users. Typically a data center has physical rack structures with attendant power and communication connections. The racks are arranged in rows throughout the room or rooms of the data center. Each rack includes a frame that has vertically oriented slots or chassis that may hold multiple devices such as servers, switches and storage devices. There are many such devices stacked in such rack structures found in a modem data center. For example, some data centers have tens of thousands of servers and attendant storage devices and network switches. Thus, a typical data center may include tens of thousands, or even hundreds of thousands, of devices in hundreds or thousands of individual racks. Data centers typically have an administrative system in a control center to monitor and insure proper operation of the equipment. For management purposes, an administrator would like to have instantaneous knowledge of the location of devices in the rack, and the location of rack in the data center. Such information must be obtained and recorded when the data center is set up; when equipment is replaced; or when new racks of devices are added to the data center.

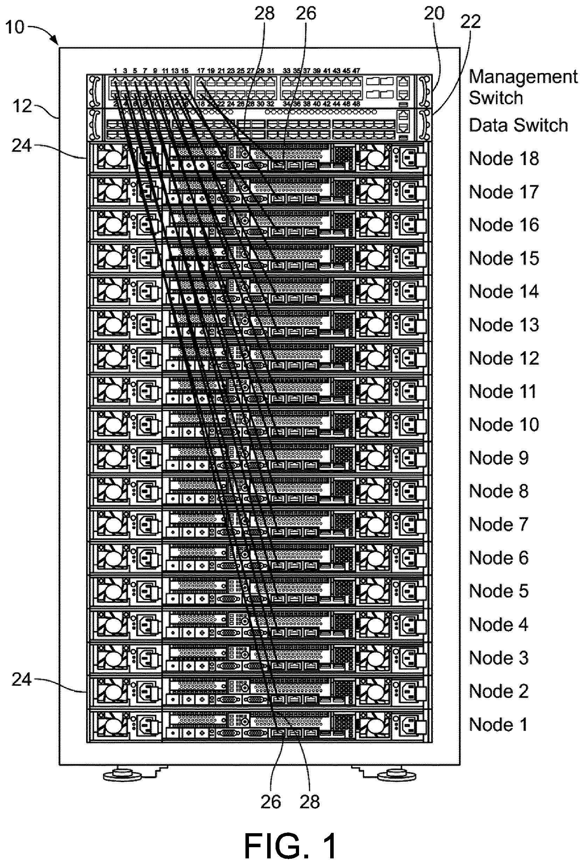

A typical rack 10 is shown in FIG. 1. The rack 10 includes a frame 12 having a set number of slots, twenty in this example. The top two slots of the frame 12 hold a management switch 20 and a data switch 22. Each of the slots has an associated circuit board (not shown) that allows for connection of different devices in the slot. As may be seen in FIG. 1, the management switch 20 and the data switch 22 each have a number of ports to allow the connection to other devices held by the frame 12. In this example, the remaining 18 slots of the frame 12 hold identical servers 24. Each of the servers 24 have a management port 26 that is connected by a cable 28 to one of the ports on the management switch 20. Other ports may be connected to the data switch (such cables have been omitted from FIG. 1 for clarity). As may be seen in FIG. 1, the nodes represented by the servers 24 in the network correspond to the number of the physical slots. When the servers 24 are connected to the management switch 20, they are connected in order from the lowest numbered port and thus are assigned a node number corresponding to the switch port number. Finding the location of a particular server 24 in the rack 10 is facilitated because the slot or chassis of the rack 10 corresponds to the node of the server 24 represented by the management switch port number. In the rack 10 in FIG. 1, since the slot numbers correspond with the node number, the location of any one of the servers 24 may be determined from a rack view map that may be determined from the slot number and identification data received by the management switch 20 through the port. Thus, if one of the servers 24 fails, location of the failed server is relatively simple because the management switch 20 is associated with the particular rack 10 and therefore the specific server may be located by the specific slot that was previously associated with the connected port number on the management switch 20.

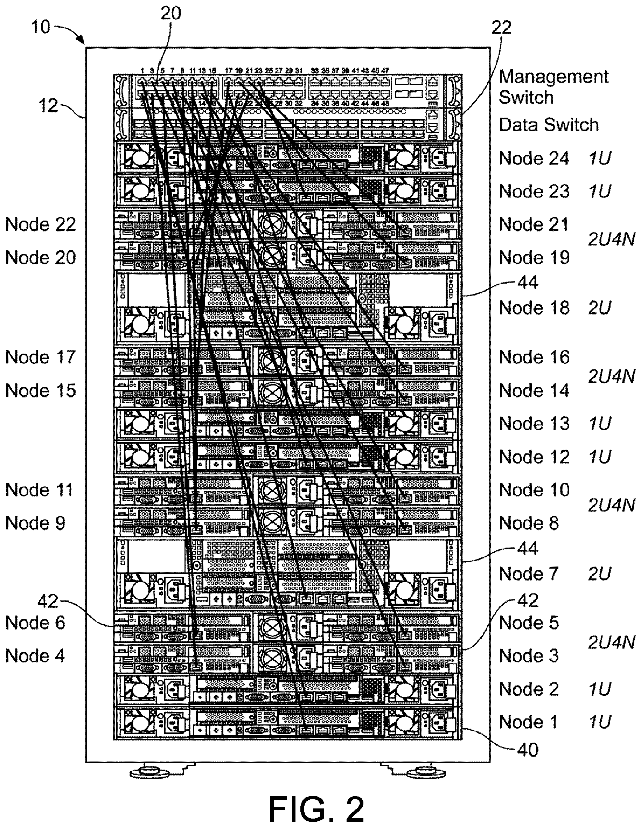

In modern data centers, the devices mounted in a rack are rarely uniform like those devices on the rack 10 in FIG. 1. FIG. 2 shows the identical rack 10 with the twenty slot frame 12 with the management switch 20 and data switch 22. However, in FIG. 2, the rack 10 has a variety of different devices that occupy different space in the rack and are connected via cables to different ports of the management switch 22. For example, two of a first type of network device 40 occupies a first and second slot similar to the network devices in FIG. 1 and therefore the first slot of the frame 12 corresponds to port 1 and the second slot of the frame 12 corresponds to port 2. However, a second type of network device 42 is small enough to occupy only half a slot. Thus two network devices 42 are mounted in the third slot of the frame 12. The network devices 42 each are respective ports 3 and 4 corresponding to one slot of the frame 12. A third type of network device 44 is large enough to occupy the fifth and sixth slots of the frame 12 and corresponds with port 7. Thus, the management switch 20 is connected to 24 nodes that are held in the twenty slots of the frame 12. Thus, the more complex rack configuration in FIG. 2 includes 6 one slot servers 40, 2 two slot servers 44 and twelve servers 42 that occupy half of a slot. The different sizes of the servers 40, 42 and 44 do not allow the correspondence of slot location to ports. Useful location information cannot be determined by the management switch 20 because the nodes do not match the slots in the rack 12. Thus, using the above method to correlate the node numbers to slot numbers will result in an inaccurate rack map that includes 24 slots and 24 devices.

If a specific device must be located such as in the case a network device fails, a network administrator will receive a notification. The network administrator must physically determine the location of the actual device by looking at the rack 10 since the slot or each of the devices in FIG. 2 does not match the port number of the management switch 20 due to the non-uniform sizes of the servers 40, 42 and 44.

Thus, there is a need for a system to allow efficient tracking of the location of equipment and racks in a data center. There is also a need for a system that allows automatic recording and transmission of location information of newly installed equipment on racks to a remote location. There is a further need for an efficient mechanism for recording identification and location data for equipment during installation in a data center that may be performed automatically upon connection to a management switch of the installed equipment.

### SUMMARY

One disclosed example is a method of determining the location of devices in an equipment rack having a plurality of slots. One of the slots holds a management switch including a plurality of ports. Each of a plurality of network devices is installed in one of the plurality of slots. Each of the plurality of network devices is connected to one of the plurality of ports of the management switch sequentially according to the switch port of each of the plurality of network devices. Identification information associated with the management switch is sent to each of the plurality of network devices. Device identification data is determined for each of the plurality of network devices. Storing slot location information for each device is stored based on the identification information associated with the management switch and the device identification data associated with each network device.

Another example is a method of creating a rack view of a plurality of network devices installed in a plurality of slots on a rack. The rack includes a management switch including a plurality of ports in one of the plurality of slots. Each of the plurality of network devices is installed in one of the slots and is connected to one of the plurality of ports of the management switch sequentially according to the location of the network device. Identification information associated with the management switch is sent to each of the plurality of network devices. Device identification data of each of the plurality of network devices is associated with the slot the network device is installed in. Rack location information is determined based on the identification information associated with the management switch and device identification data of each network device. A rack view of the network devices is generated based on the rack location information.

The above summary is not intended to represent each embodiment or every aspect of the present disclosure. Rather, the foregoing summary merely provides an example of some of the novel aspects and features set forth herein. The above features and advantages, and other features and advantages of the present disclosure, will be readily apparent from the following detailed description of representative embodiments and modes for carrying out the present invention, when taken in connection with the accompanying drawings and the appended claims.

### BRIEF DESCRIPTION OF THE DRAWINGS

The disclosure will be better understood from the following description of exemplary embodiments together with reference to the accompanying drawings, in which:
FIG. 1 shows a prior art equipment rack in a data center with identical network devices that allows for automatic mapping based on the slot and port numbers;
FIG. 2 shows a prior art equipment rack in a data center with different types of network devices, where the slot and port numbers are not correlated;
FIG. 3 is a data center equipment rack having different types of network devices with information obtained from one procedure to learn the location of the network devices;
FIG. 4 is a block diagram of the devices and management switch in FIG. 3;
FIG. 5 is a data center equipment rack with information obtained from another procedure, to learn the location of the devices on the rack;
FIG. 6 is a data center equipment rack with information obtained from another procedure, to learn the location of the devices on the rack;
FIG. 7 is a data center equipment rack with information obtained from another procedure, to learn the location of the devices on the rack; and
FIG. 8 is a flow diagram of the process of determining location information of network devices in a rack, for a rack view.

The present disclosure is susceptible to various modifications and alternative forms, and some representative embodiments have been shown by way of example in the drawings and will be described in detail herein. It should be understood, however, that the invention is not intended to be limited to the particular forms disclosed. Rather, the disclosure is to cover all modifications, equivalents, and alternatives falling within the spirit and scope of the invention as defined by the appended claims.

### DETAILED DESCRIPTION OF THE ILLUSTRATED EMBODIMENTS

The present inventions can be embodied in many different forms. Representative embodiments are shown in the drawings, and will herein be described in detail, with the understanding that the present disclosure is an example or illustration of the principles of the present disclosure and is not intended to limit the broad aspects of the disclosure to the embodiments illustrated. To that extent, elements and limitations that are disclosed, for example, in the Abstract, Summary, and Detailed Description sections, but not explicitly set forth in the claims, should not be incorporated into the claims, singly or collectively, by implication, inference, or otherwise. For purposes of the present detailed description, unless specifically disclaimed, the singular includes the plural and vice versa; and the word "including" means "including without limitation." Moreover, words of approximation, such as "about," "almost," "substantially," "approximately," and the like, can be used herein to mean "at, near, or nearly at," or "within 3-5% of," or "within acceptable manufacturing tolerances," or any logical combination thereof, for example.

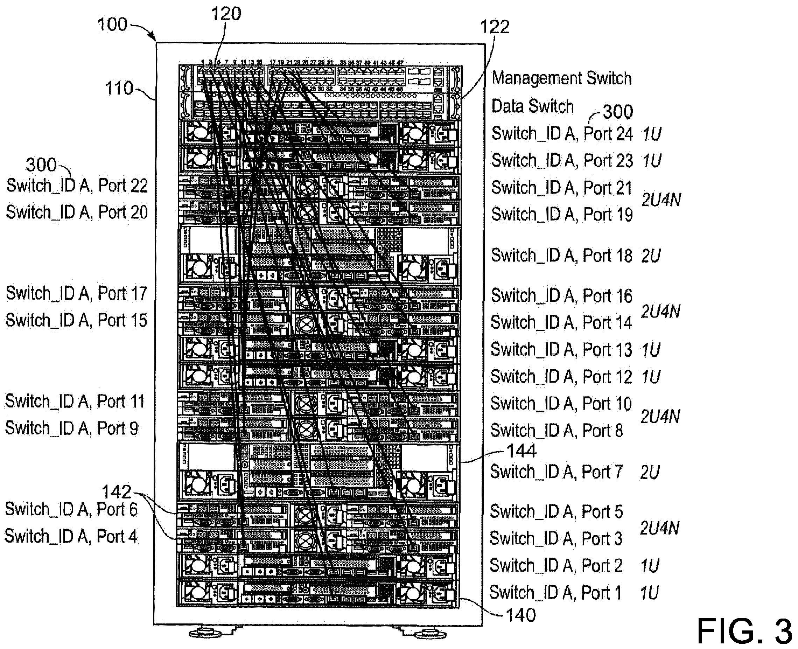

FIG. 3 shows an equipment rack 100 that may reside in a data center. The equipment rack 100 includes a rack frame 110 having a number of slots or chassis. Each of the slots may hold at least one network device such as a server associated with the rack 100. Other network devices such as switches, routers, servers, etc.

In this example, the rack frame 110 includes 20 separate slots or chassis that mat be designated U1-U20 from bottom to top. Of course, the rack frame 110 may include fewer or more slots. The slots or chassis may also be designated with the highest number at the top and the lowest number at the bottom. Each of the slots may hold one or more network devices. Alternatively, a larger network device may occupy two or more slots. Of course certain slots may be unoccupied by devices. In this example, the top two slots (U19 and U20) hold a management switch 120 and a data switch 122 respectively. Each of the switches 120 and 122 include multiple ports for connecting cables to the other network devices held by the slots in the rack frame 110.

In this example, the rack frame 110 includes three different types of network devices, which are servers in this example. A first network device 140 occupies one slot. A second network device 142 occupies half of a slot. A third network device 144 occupies two slots of the rack frame 110. As shown in FIG. 3, each of the network devices 140, 142 and 144 are placed in different slots in the rack frame 110. As will be explained below, each of the slots has an associated circuit board to allow connection to a device or devices such as one or more of the network devices 140, 142 and 144. Each of the network devices 140, 142 and 144 are connected via a cable to a port of the management switch 120. In this example, the network device (network device 140) in the bottom slot or chassis (U1) is connected to port 1 of the management switch 120, and each successive device in each slot is connected to a numerically successive port of the management switch 120. Thus, a second network device 140 is located in the next slot and is connected to port 2 of the management switch 120. As shown in FIG. 3, multiple devices 142 in one slot are connected in succession to ports on the management switch 120. In this example when multiple devices 142 occupy a single slot, the rightmost device is assigned the lower number port number (e.g., port 3) and each successive device on that slot is assigned the next successive port number (e.g., port 4).

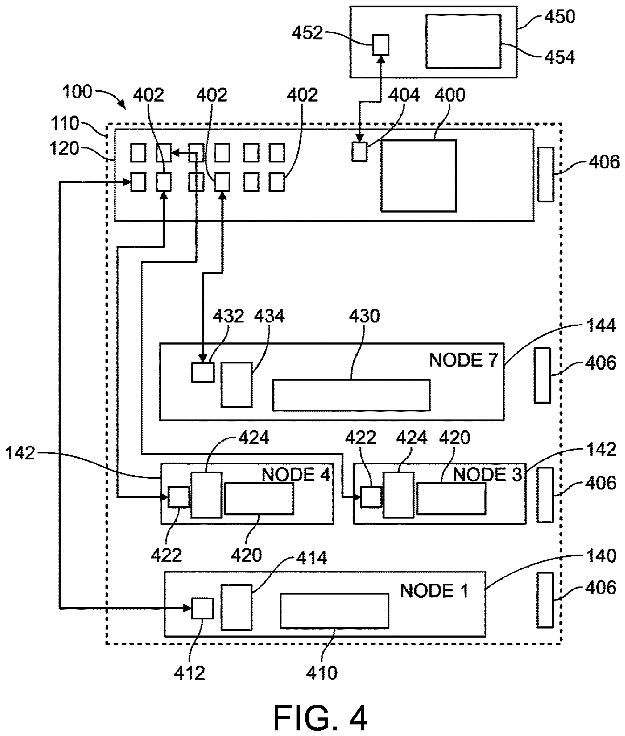

FIG. 4 is a block diagram of the management switch 120 and certain network devices 140, 142 and 144 held by the frame rack 110 in FIG. 3. The management switch 120 includes a switch controller 400 that is coupled to ports 402. The switch controller 400 is also coupled to a management port 404 that is connected to a management controller 450 via a port 452. The management controller 450 is coupled to multiple management switches. Each switch such as the management switch 120 is associated with one of multiple racks of equipment such as the rack 100. Each rack contains network devices coupled to the corresponding management switch. Thus, the management controller 450 allows a network or data center administrator to monitor the operation of multiple racks of network devices.

Each of the ports 402 of the management switch 120 is connected to one of the network devices 140, 142 and 144. Each of the slots in the rack 100 has an interface circuit 406 that may be connected to one or more network devices to provide electrical connections such as power or data signals. In this example, each of the network devices 140, 142 and 144 are different types of servers, but any other type of network device may be connected to the management switch 120. In this example, the network device 140 in the first slot includes a baseboard management controller 410 that is connected to the management switch 120 via a port 412. The baseboard management controller 410 is connected to a network interface card (NIC) 414 that is connected to the port 412 that communicates with the management switch 120. The NIC may be a separate component, integrated into a processor or be an on board controller such as the baseboard management controller 410. In this example the lowest number port is coupled to the device installed in the bottom slot or chassis, which is the device 140 in FIG. 3. Similarly, the network devices 142 each have a baseboard management controller 420, port 422 and a NIC 422. The network devices 142 are assigned higher numbered ports in order from the right side of FIG. 3 to the left side. The device 144 also includes a baseboard manager 430, a port 432 and a NIC 434. The device 144 is on a higher slot in the frame rack 110, and thus is assigned a higher port number by the management controller 400. When the devices 140, 142 and 144 are installed in the frame rack 110, the device in the lowest slot is connected to the lowest number port and each successive device is connected to a higher number port.

A first procedure to determine the slot or chassis location of the devices in the rack frame 110 in FIG. 3 involves connecting the network interface card (NIC) via a port such as the port 412 of each device such as the devices 140, 142 and 144 to the management switch 120 for each device in FIG. 1. Each port is connected in the numerical order of the slots of the rack frame 110. As explained above, a slot with multiple devices is connected with the lowest number port to the right most device and the next number port to the next device in the slot. After each of the devices such as devices 140, 142 and 144 are connected to the ports 402 of the management switch 120, the management controller 400 sends a link level discovery protocol (LLDP) signal to each of the connected devices. Through the LLDP signal, each device learns the switch ID or chassis ID associated with the management switch 120. The switch ID may be a switch service port MAC address, or a UUID or a serial number of the management switch 120. The switch ID may also be a serial number of the field-replaceable unit (FRU) or manually assigned by a user. The chassis ID may be an identification associated with the interface circuit 406 that is connected to the management switch 120. Since the switch ID or chassis ID is unique to the management switch 120, it may be used to identify the rack 100 and thus associate all of the connected devices to the rack 100.

Optionally, the management controller 120 may send the corresponding switch port number to all of the devices to identify the neighboring devices to each device. FIG. 3 shows a table 300 that shows the information learned by each device including the switch ID and the port number. Based on the LLDP message, each device learns the switch ID (in this example, "A") and the port number (1-24). The switch port number is a unique identification of the rack 100 and thus, the devices may be matched with the known location order of slots in the rack 100. Once the location of the devices is learned, the devices may be mapped for the particular rack 100 by a network system.

Another procedure in obtaining the information of locations of the devices in the rack frame 110 is using the chassis or frame identification number and the identification of circuit boards in each of the devices 140, 142 and 144.

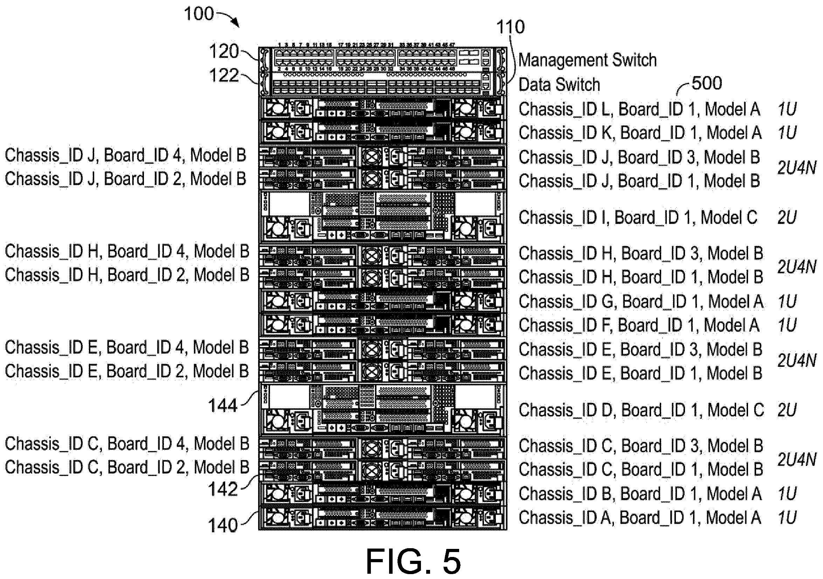

FIG. 5 shows a table 500 of information for a rack view of the network devices installed in the rack 100 that may be determined by a second procedure. As shown in table 500, the procedure allows each network device to be assigned the chassis identification number corresponding to the slot of the rack frame 110, a board identification number unique to the device and a model number representing the type of the network device. The second procedure uses a field-replaceable unit (FRU) on one of the boards such as the interface circuit 406 or a chassis backplane for the slot in the rack frame 110 to determine the chassis or slot identification. First, the baseboard management controllers 410, 420 and 430 on each of the devices 140, 142 and 144 shown in FIG. 4 learn the chassis ID from a FRU such as a main board FRU or front panel FRU in the interface circuit 406. The chassis ID may be any unique number associated with the slot. In a slot with a single network device, the chassis ID defines a unique identification for the particular slot. For example the chassis serial number of the slot can be programmed in the FRU. The chassis ID is programmed in the manufacturing of the board in either the main or panel FRU. In other examples, the chassis ID is mapped to a chassis box and not a slot in the frame. For example, a 2 unit 4 node system belongs to same chassis, so the chassis serial number in a shared front panel FRU can be the Chassis ID, a one unit system is a single system belonging to a single chassis, so the chassis serial number in a main board FRU can be the chassis ID.

If the network device is in a single node in a slot such as the network device 140, the serial number that may serve as the chassis ID may be taken from a serial number programmed in the main board FRU. If the slot has multiple nodes, such as the network devices 142 (in FIG. 5), all the devices 142 in the same chassis can access the same chassis FRU to share the same chassis ID. Another example implementation is a controller in a chassis that can report the chassis serial number read from a chassis FRU or from a shared front panel FRU of the chassis or any other unique identification to all of the BMCs of the network devices 140, 142 and 144. In such a manner all of the BMCs in the equipment rack 110 know the unique IDs.

Thus, the baseboard management controllers 410, 420 and 430 in FIG. 4 for each of the respective devices 140, 142 and 144 learn their respective board identification. If the slot has multiple nodes, each board in each device such as the devices 142 may have a hardware board ID in general purpose input/output (GPIO) signals from the chassis backplane such as the interface circuit 406 in FIG. 4 to provide in chassis location information (the board ID) to the baseboard management controller. The baseboard management controller in the device 142 may use general purpose input/output (GPIO) pins that are connected to the chassis backplane to read the hardware board ID and generate chassis location information.

Each of the baseboard management controllers of the devices 140, 142 and 144 then report the model name or chassis dimension information of the device to the management switch 120. Each device has identification data to express the model name of the device. For example, the model name may be a product name or model number. The model name may be programmed in a FRU in the device or may be in a hardcode in the baseboard management controller or BIOS that can identify different models of the product. The baseboard management controller may report chassis dimension information to the management switch 120 or data center management software running on a management controller such as the management controller 450 in FIG. 4. The chassis dimension information may be provided by an API via IPMI, Redfish or other protocol that may provide the same information to the management software. In this manner, the management controller such as the management controller 450 of the management system for the data center can correlate the node numbers to the physical location of the devices in the chassis. Alternatively, this process may be performed by the controller 400 of the management switch 120.

For example, the model number or chassis dimension will allow the management controller to determine the number of slots occupied by each of the devices. In the case that multiple devices occupy a single slot, the board ID will allow the management controller to determine the location of the device in the slot. A rack view would include information on the rack 100 generated from the ID of the management switch 120. As shown in table 500, the location of an individual device could be determined based on the specific chassis ID based on the number of physical slots in the rack 100 and the mapping of each device 140, 142 and 144 to a specific slot depending on the slot or slots occupied by the device based on the model number or chassis dimension.

Another procedure to generate device location information for a rack view is for each of the baseboard management controllers 410, 420 and 430 in FIG. 4 of the devices 140, 142, 144 to report the location information of the respective device to data center management software executed by the management controller 450. The location information may include: (1) the switch ID of the management switch 120 learned from the LLDP message from the management switch 122; (2) the switch port number learned from LLDP message (3) the chassis ID learned from the FRU of a chassis board; (4) the board ID from the GPIO of a chassis backplane; and (5) the model name from the device baseboard management controller or BIOS. This information is compiled by each device and sent to the management switch 120 or the management controller 450 in FIG. 4.

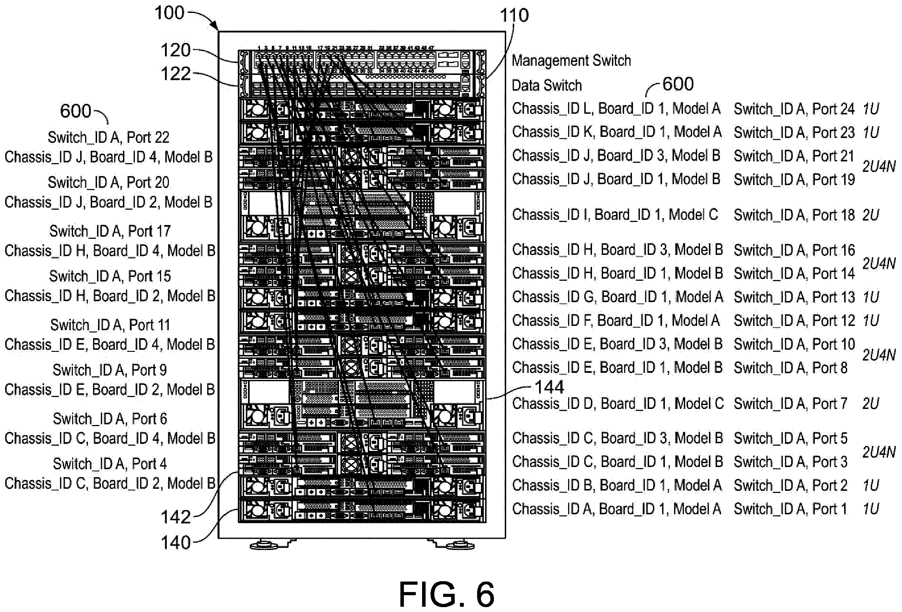

A table 600 shown in FIG. 6 shows the information generated from this procedure that may be used to generate a rack view for the rack 100. As shown in table 600, each of the devices such as the device 144 connected to port 7 has the switch ID (A) associated with the management switch 120, a port number (e.g. port 7), the slot or chassis ID (e.g., chassis D), the board ID (e.g., board 1) and the model name (e.g., C). The switch ID associated with the management switch 120 is correlated with the specific rack 100. The model number or chassis dimension will allow the management controller to determine the number of slots occupied by the device and thereby generated the chassis ID. In the case that multiple devices occupy a single slot, the board ID (e.g., 2 for one of the devices 142) will allow the management controller to determine the location of the device 142 in the slot (e.g., chassis ID C). A rack view would include information on the rack 100 generated from the switch ID of the management switch 120. As shown in table 600, the location of an individual device could be determined based on the specific chassis ID and management switch port number. The mapping of each device 140, 142 and 144 to a specific slot depending on the slot or slots occupied by the device may be determined based on the model number or chassis dimension and board ID.

Another procedure to determine the physical location of devices for a rack assembly view is based on external management software to build location information for each of the network devices in a rack, such as the rack assembly 110. This procedure uses the switch ID of the management switch 120 as the server rack identification. The model number and chassis dimension information may be obtained from the baseboard management controller of each of the devices 140, 142 and 146.

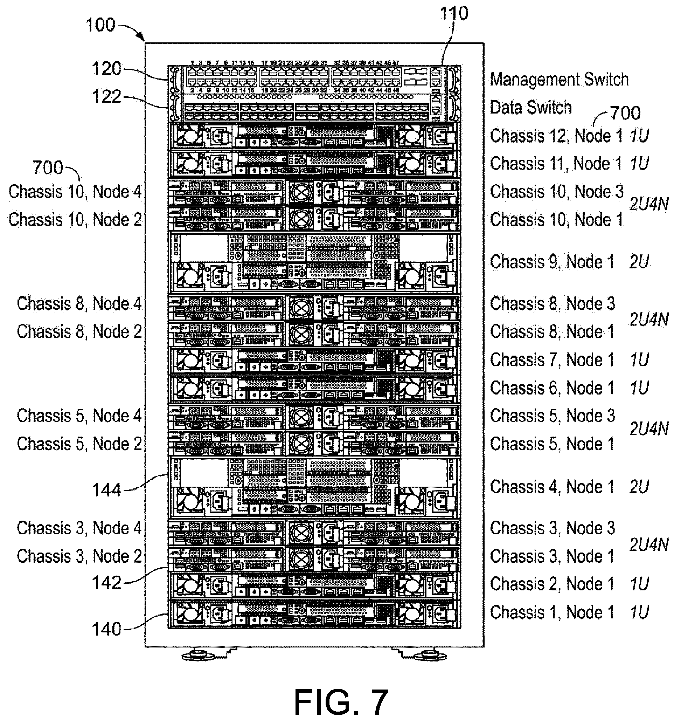

The procedure based on the information in FIG. 7, determines location related chassis identification. Each chassis or slot in the rack 100 has a minimum chassis port number, which represents the minimum number of BMC neighbor management switch port numbers that belong to same slot or chassis, For example Chassis 3 in FIG. 7 includes two slots with four nodes. The slots thus include four nodes whose baseboard management controllers are connected to switch ports 3, 4, 5 and 6 of the management switch 120. In this example, the Min_Chassis_Port_Number is 3. Based on the Min_Chassis_Port_Number value, the management software can sort all of the Chassis Min_Chassis_Port_Numbers and provide a Chassis Location ID from 1 to N that can map the devices in a slot or chassis location in a rack.

For example, FIG. 7 shows a sorting chassis number that is numbered 1 to 12 to determine an in rack slot or chassis location for each of the network devices 140, 142 and 144. The system then determines an in Chassis Node Number that is unique to each network device that is determined by the board ID. The management switch 120 may direct each baseboard management controller to determine a corresponding Board identification for the device. FIG. 7 shows that each device is assigned a chassis number and a node number for the corresponding chassis based on the board ID. Based on the model name or the chassis dimension information that is summarized in a table 700, each chassis may be mapped to a real physical view of the location of the devices as shown in the images of the devices 142, 144 and 146 in FIG. 7. Thus, each device is mapped to a slot or slots based on the model number or the chassis dimension information and the port number. The real physical view in FIG. 7 may be generated by assigning a graphical image to each of the different model device and using the logical slot number or chassis information to arrange the graphical images in the same order as the physical location of the devices in the rack 100.

Based on above algorithms that determine the chassis ID for the rack and identification information associated with each device, a useful rack view of the devices in the rack 100 may be constructed. One example of a rack view is the image shown in FIG. 7 that shows graphical images of the different types of network devices and their relative location in the rack 100. FIG.7 is shown in graphical format but the rack view may have more or less detailed graphics or be in a text format.

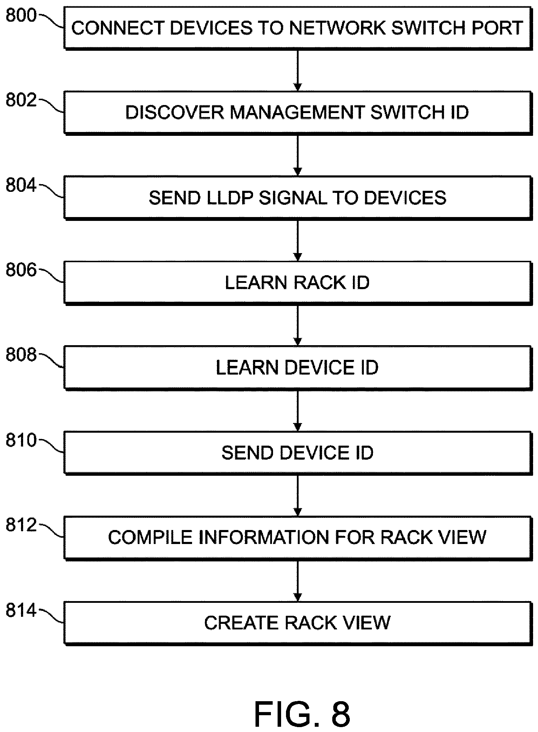

FIG. 8 shows a flow diagram of the code executed by the management switch 120 in FIG. 4 or the management controller 450 in FIG. 4 to generate location information using the connection of the devices 140, 142 and 144 to management switch ports in FIGs. 3-4. The flow diagram in FIG. 8 is representative of example machine readable instructions for the management switch 120 or the management controller 450 (in FIG. 4). In this example, the machine readable instructions comprise an algorithm for execution by: (a) a processor, (b) a controller, and/or (c) one or more other suitable processing device(s). The algorithm may be embodied in software stored on tangible media such as, for example, a flash memory, a CD-ROM, a floppy disk, a hard drive, a digital video (versatile) disk (DVD), or other memory devices, but persons of ordinary skill in the art will readily appreciate that the entire algorithm and/or parts thereof could alternatively be executed by a device other than a processor and/or embodied in firmware or dedicated hardware in a well-known manner (e.g., it may be implemented by an application specific integrated circuit (ASIC), a programmable logic device (PLD), a field programmable logic device (FPLD), a field programmable gate array (FPGA), discrete logic, etc.). For example, any or all of the components of the interfaces could be implemented by software, hardware, and/or firmware. Also, some or all of the machine readable instructions represented by the flowchart of FIG. 8 may be implemented manually. Further, although the example algorithm is described with reference to the flowcharts illustrated in FIG. 8, persons of ordinary skill in the art will readily appreciate that many other methods of implementing the example machine readable instructions may alternatively be used. For example, the order of execution of the blocks may be changed, and/or some of the blocks described may be changed, eliminated, or combined.

In this example, the management switch 120 is installed in the highest numbered slot in the rack 100 in FIG. 3. Each of the network devices 140, 142 and 144 are installed in the lower numbered slots or chassis in the rack assembly 110 in FIG. 3. Each of the devices 140, 142, and 144 are connected to a port on the management switch 120 in sequential order based on the chassis or slot of the device (800). The controller 400 of the management switch 120 in FIG. 4 discovers the management switch ID based on the switch ID or chassis ID that is then associated with the rack 100 and becomes the rack ID (802). The management switch sends a LLDP signal to all of the connected network devices that contains the rack ID (804).

Each of the devices receives the LLDP signal and learns the rack ID associated with the rack 100 (806). The LLDP signal may include other information such as the port number or the port numbers of the neighboring devices. Each of the network devices 140, 142 and 144 learn device identification information for the device (808). As explained above, the device ID may include a chassis ID based on an FRU, a model name and number based on the baseboard management controller or BIOS, chassis dimension or other unique information for the device. Each of the devices sends the device identification to the management switch 120 (810) or the management controller 450.

The management switch 120 in FIG. 4 then compiles the device identification information that includes the rack identification of the rack 100 in FIG. 3 and slot or chassis associated with each of the devices in FIGs. 3-4 (812). Using this information and the number of logical slots in the rack 100 in FIG. 3, the management switch 120 in FIG. 4 sorts the devices and assigns the physical location in each slot for each device. Thus, this information allows the creation of a rack view (814) that includes the specific location of every device on a rack such as the rack 100.

As used in this application, the terms "component," "module," "system," or the like, generally refer to a computer-related entity, either hardware (e.g., a circuit), a combination of hardware and software, software, or an entity related to an operational machine with one or more specific functionalities. For example, a component may be, but is not limited to being, a process running on a processor (e.g., digital signal processor), a processor, an object, an executable, a thread of execution, a program, and/or a computer. By way of illustration, both an application running on a controller, as well as the controller, can be a component. One or more components may reside within a process and/or thread of execution and a component may be localized on one computer and/or distributed between two or more computers. Further, a "device" can come in the form of specially designed hardware; generalized hardware made specialized by the execution of software thereon that enables the hardware to perform specific function; software stored on a computer-readable medium; or a combination thereof.

Computing devices typically include a variety of media, which can include computer-readable storage media and/or communications media, in which these two terms are used herein differently from one another as follows. Computer-readable storage media can be any available storage media that can be accessed by the computer, is typically of a non-transitory nature, and can include both volatile and nonvolatile media, removable and non-removable media. By way of example, and not limitation, computer-readable storage media can be implemented in connection with any method or technology for storage of information such as computer-readable instructions, program modules, structured data, or unstructured data. Computer-readable storage media can include, but are not limited to, RAM, ROM, EEPROM, flash memory or other memory technology, CD-ROM, digital versatile disk (DVD) or other optical disk storage, magnetic cassettes, magnetic tape, magnetic disk storage or other magnetic storage devices, or other tangible and/or non-transitory media that can be used to store desired information. Computer-readable storage media can be accessed by one or more local or remote computing devices, e.g., via access requests, queries or other data retrieval protocols, for a variety of operations with respect to the information stored by the medium.

The terminology used herein is for the purpose of describing particular embodiments only, and is not intended to be limiting of the invention. As used herein, the singular forms "a", "an" and "the" are intended to include the plural forms as well, unless the context clearly indicates otherwise. Furthermore, to the extent that the terms "including", "includes", "having", "has", "with", or variants thereof, are used in either the detailed description and/or the claims, such terms are intended to be inclusive in a manner similar to the term "comprising."

Unless otherwise defined, all terms (including technical and scientific terms) used herein have the same meaning as commonly understood by one of ordinary skill in the art. Furthermore terms, such as those defined in commonly used dictionaries, should be interpreted as having a meaning that is consistent with their meaning in the context of the relevant art, and will not be interpreted in an idealized or overly formal sense unless expressly so defined herein.

While various embodiments of the present invention have been described above, it should be understood that they have been presented by way of example only, and not limitation. Numerous changes to the disclosed embodiments can be made in accordance with the disclosure herein, without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur or be known to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method of determining the location of devices in an equipment rack (100) having a plurality of slots, wherein one of the slots holds a management switch (120) including a plurality of ports (402), and wherein the method comprises:
installing each of a plurality of network devices (140) in one of the plurality of slots;
connecting each of the plurality of network devices (140) to one of the plurality of ports (402) of the management switch (120) sequentially, according to the port of each of the plurality of network devices (140);
sending identification information associated with the management switch (120) to each of the plurality of network devices (140);
determining device identification data for each of the plurality of network devices (140); and
storing slot location information for each device based on the identification information associated with the management switch (120), and the device identification data associated with each network device (140).

2. The method of claim 1, wherein the identification information associated with the management switch (120) includes a rack ID or a switch ID, and preferably wherein the identification information associated with the management switch (120) is the rack ID or the switch ID.

3. The method of claim 1 or 2, wherein the identification information associated with the management switch (120) is sent in a link level discovery protocol signal.

4. The method of anyone of the claims 1 to 3, wherein the identification information associated with the management switch (120) includes the port number assigned to the network device (140).

5. The method of anyone of the claims 1 to 4, wherein the device identification data includes a model name or a model number of the network device (140).

6. The method of anyone of the claims 1 to 5, wherein the device identification data includes a serial number determined from a field-replaceable unit on the network device (140) or a field-replaceable unit shared by multiple network devices (140).

7. The method of anyone of the claims 1 to 6, wherein the device identification data includes a chassis dimension associated with the network device (140).

8. The method of anyone of the claims 1 to 7, wherein each of the plurality of network devices (140) has a baseboard management controller (410) that determines the device identification data.

9. The method of claim 8, wherein the baseboard management controller (410) sends the device identification data to the management switch (120), and wherein the management switch (120) determines the slot location information.

10. The method of anyone of the claims 1 to 9, wherein at least two of the network devices (140) are installed on one of the plurality of slots.

11. The method of anyone of the claims 1 to 10, wherein at least one of the network devices (140) is installed in two of the plurality of slots.

12. The method of anyone of the claims 1 to 11, further comprising generating a rack view for locating any of the network devices (140), and the rack view is determined from the slot location information.

13. The method of claim 12, wherein the rack view includes graphical images representing each of the network devices (140) and the respective location in the slots.

14. A method of creating a rack view of a plurality of network devices (140) installed in a plurality of slots on a rack, wherein the rack includes a management switch (120) that includes a plurality of ports (402) in one of the plurality of slots, wherein each of the plurality of network devices (140) is installed in one of the slots, and is connected to one of the plurality of ports (402) of the management switch (120) sequentially, according to the location of the network device (140), and wherein the method comprises:
sending identification information associated with the management switch (120) to each of the plurality of network devices(140);
associating device identification data for each of the plurality of network devices (140) with the slot the network device (140) is installed in;
determining rack location information based on the identification information associated with the management switch (120), and device identification data of each network device (140); and
generating a rack view of the network devices (140) based on the rack location information.

15. The method of claim 14, wherein the rack view includes graphical images representing each of the network devices (140) and the respective location in the slots.
